(19) Europäisches Patentamt
European Patent Office
Office européen des brevets

(11) **EP 4 307 075 A1**

(12) **EUROPÄISCHE PATENTANMELDUNG**

(43) Veröffentlichungstag:
**17.01.2024   Patentblatt 2024/03**

(21) Anmeldenummer: **22185229.6**

(22) Anmeldetag: **15.07.2022**

(51) Internationale Patentklassifikation (IPC):
**G05F 1/56** *(2006.01)*      **H03M 1/66** *(2006.01)*
**H03M 1/78** *(2006.01)*

(52) Gemeinsame Patentklassifikation (CPC):
**G05F 1/561; H03M 1/785**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Pepperl+Fuchs SE**
**68307 Mannheim (DE)**

(72) Erfinder:
• **Delic, Edin**
**68307 Mannheim (DE)**
• **Schulz, Enrico**
**68307 Mannheim (DE)**
• **Elter, Johann**
**68307 Mannheim (DE)**
• **Speckmann, Christian**
**68307 Mannheim (DE)**

(74) Vertreter: **Banse & Steglich**
**Patentanwälte PartmbB**
**Patentanwaltskanzlei**
**Herzog-Heinrich-Straße 23**
**80336 München (DE)**

(54) **SPANNUNGSGESTEUERTE STROMQUELLE**

(57)     Die Erfindung betrifft eine spannungsgesteuerte Stromquelle (1) zum Bereitstellen eines gewünschten Laststroms durch eine Lastimpedanz ($R_L$) an einem Ausgang der Stromquelle abhängig von einer Steuerspannung ($U_{Steuer}$), umfassend:
- eine Steuerspannungsquelle (3) zum Bereitstellen der Steuerspannung ($U_{Steuer}$);
- einen Differenzverstärker (2) mit einem Ausgang, der auf jeden der Eingänge (E1, E2) des Differenzverstärkers (2) über einen jeweiligen Rückkopplungswiderstand rückgekoppelt ist, wobei einer der Eingänge (E2) mit der Steuerspannungsquelle (3) elektrisch gekoppelt ist,
- eine Spannungsmesseinheit (4) zum Erfassen einer Messspannung ($U_{mess}$) an dem Ausgang ($K_1$) des Differenzverstärkers (2);
wobei die Steuerspannungsquelle (3) ausgebildet ist, um abhängig von der Messspannung ($U_{mess}$) die Steuerspannung ($U_{Steuer}$) des Steuersignals einzustellen, so dass der gewünschte Laststrom eingestellt wird.

Fig. 1

**Beschreibung**

Technisches Gebiet

Die Erfindung betrifft elektronische Schaltungen, insbesondere spannungsgesteuerte Stromquellen, die insbesondere mithilfe eines Mikrocontrollers realisiert werden können.

Technischer Hintergrund

Herkömmliche Schaltungen für spannungsgesteuerte Stromquellen benötigen in der Regel aufeinander abgestimmte Widerstände und ideale Spannungsquellen. Ideale Spannungsquellen entsprechen Spannungsquellen ohne Innenwiderstand, wohingegen reale Spannungsquellen häufig einen unbekannten Innenwiderstand aufweisen. Werden zur Realisierung von spannungsgesteuerten Stromquellen hochohmige Steuersignale mit unbekanntem Innenwiderstand verwendet, so ist der eingestellte Ausgangsstrom abhängig von dem unbekannten, toleranzbehafteten Innenwiderstand des das Steuersignal bereitstellenden Schaltungsteils sowie der Lastimpedanz.

Spannungsgesteuerte Stromquellen können mithilfe eines symmetrisch rückgekoppelten Differenzverstärkers und einer Spannungsquelle ausgebildet werden, wie beispielsweise bekannt aus U. Tietze, T. Schenk, 2019, Kapitel 11.3.2. Bei dieser Konfiguration tritt bei asymmetrischen Impedanzen in den Rückkopplungspfaden bei einer Änderung der Lastimpedanz ein Fehler im Ausgangsstrom auf.

Bei der Verwendung eines Mikrocontrollers mit integriertem DA-Wandler zum Bereitstellen des Steuersignals und des Differenzverstärkers kann die spannungsgesteuerte Stromquelle in kostengünstiger Weise realisiert werden. Häufig verwenden Mikrocontroller Digital-/Analog-Converter zum Bereitstellen eines Steuersignals in Form einer Steuerspannung, wobei der Digital-/Analog-Converter beispielsweise mithilfe eines R2R-Netzwerks realisiert ist. Da selbst bei integrierter Ausbildung des R2R-Netzwerks die gleichartigen Widerstände Toleranzen in ihren Widerstandswerten aufweisen können, ist der Innenwiderstand einer so gebildeten Steuerspannungsquelle ebenfalls toleranzbehaftet. Dieser Nachteil kann mit einem nachgeschalteten Impedanzwandler reduziert werden. Oftmals kommt der interne Impedanzwandler jedoch nicht an die Versorgungsgrenzen, d. h. die obere und untere Versorgungsspannung des Mikrocontrollers, so dass der Arbeitsbereich der spannungsgesteuerten Stromquelle eingeschränkt ist. Ein externer Impedanzwandler verursacht insbesondere bei einer diskreten Aufbauweise auf der Leiterplatte zusätzliche Kosten und benötigt zusätzlichen Platz.

Es ist Aufgabe der vorliegenden Erfindung, eine verbesserte, bauteiltoleranzunabhängige spannungsgesteuerte Stromquelle bereitzustellen, die insbesondere mithilfe eines Mikrocontrollers aufgebaut werden kann.

Insbesondere ist es Aufgabe der vorliegenden Erfindung, eine möglichst von einem Innenwiderstand eines steuersignalbereitstellenden Schaltungsteils unabhängige sowie eine lastunabhängige, spannungsgesteuerte Stromquelle bereitzustellen.

Offenbarung der Erfindung

Diese Aufgabe wird durch die spannungsgesteuerte Stromquelle gemäß Anspruch 1 sowie durch das Verfahren zum Kalibrieren einer solchen spannungsgesteuerten Stromquelle gelöst.

Weitere Ausgestaltungen sind in den abhängigen Ansprüchen angegeben.

Gemäß einem ersten Aspekt ist eine spannungsgesteuerte Stromquelle zum Bereitstellen eines gewünschten Laststroms durch eine Lastimpedanz an einem Ausgang der Stromquelle abhängig von einer Steuerspannung vorgesehen, umfassend:

- eine Steuerspannungsquelle zum Bereitstellen einer Steuerspannung;
- einen Differenzverstärker mit einem Ausgang, der auf jeden der Eingänge des Differenzverstärkers über einen jeweiligen Rückkopplungswiderstand rückgekoppelt ist, wobei einer der Eingänge mit der Steuerspannungsquelle elektrisch gekoppelt ist,
- eine Spannungsmesseinheit zum Erfassen einer Messspannung an dem Ausgang des Differenzverstärkers;

wobei die Steuerspannungsquelle ausgebildet ist, um abhängig von der Messspannung die Steuerspannung einzustellen, so dass der gewünschte Laststrom eingestellt wird.

Die hierin betrachtete Schaltung für eine spannungsgesteuerte Stromquelle weist im Kern einen Differenzverstärker auf, der an einem Ausgang eine Spannung ausgibt, die über einen Kopplungswiderstand und einen an einem Ausgangsknoten der Stromquelle anliegenden Lastwiderstand einen vorgegebenen Strom einprägt. Der Ausgangsknoten ist auf einen Eingang des Differenzverstärkers über mindestens einen Widerstand rückgekoppelt. Ändert sich der Lastwiderstand, so ändert sich dadurch entsprechend die Spannung am Ausgang des Differenzverstärkers, was ein Nachregeln der Kompensationsspannung nach sich zieht, so dass der Laststrom durch den Lastwiderstand entsprechend konstant bleibt.

Ein erster Eingang des Differenzverstärkers ist insbesondere direkt über einen ersten Serienwiderstand mit einem niedrigen Versorgungspotenzial und über einen ersten Rückkopplungswiderstand mit dem Ausgang des Differenzverstärkers elektrisch verbunden.

An einem zweiten Eingang des Differenzverstärkers ist eine Steuerspannungsquelle angelegt, die über einen zweiten Serienwiderstand eine Steuerspannung an den zweiten Eingang des Differenzverstärkers insbesondere direkt anlegt. Die Steuerspannungsquelle kann einem Schaltungsteil entsprechen, der ein Steuersignal in Form einer impedanzbehafteten Steuerspannung beinhaltet. Der zweite Eingang ist über eine Serienschaltung eines zweiten Rückkopplungswiderstands und des Kopplungswiderstands mit dem Ausgang des Differenzverstärkers insbesondere direkt elektrisch verbunden.

Weiterhin kann vorgesehen sein, dass jeder der Eingänge des Differenzverstärkers insbesondere direkt über einen jeweiligen Serienwiderstand mit einem festgelegten Potenzial, insbesondere einem Versorgungspotenzial, elektrisch verbunden ist.

Es kann vorgesehen sein, dass die Steuerspannungsquelle eine Stellspannungsquelle aufweist, um eine dem gewünschten Laststrom entsprechende Stellspannung vorzugeben. Weiterhin kann die Steuerspannungsquelle eine Kompensationsspannungsquelle aufweisen, um der Stellspannung eine von der Messspannung abhängige Kompensationsspannung zu addieren, um die Steuerspannung zu erhalten.

Somit können die Toleranzen der in der Schaltung verwendeten Widerstände sowie des Innenwiderstands der Steuerspannungsquelle durch Vorsehen der Kompensationsspannungsquelle als Teil der Steuerspannungsquelle kompensiert werden. Die Kompensationsspannungsquelle wird gesteuert und liefert eine variable Kompensationsspannung, die die Stellspannung additiv beaufschlagt und die basierend auf einer Messspannung gesteuert wird. Die Messspannung kann der Spannung am Ausgang des Differenzverstärkers bezogen auf das niedrige Versorgungspotenzial bzw. auf das gleiche Referenzpotenzial wie die Steuerspannung entsprechen. Die Messspannung kann direkt oder beispielsweise mithilfe eines Spannungsteilers oder dergleichen ermittelt werden.

Die Kompensationsspannungsquelle kann ausgebildet sein oder angesteuert werden, um die Kompensationsspannung als die mit einen vorbestimmten Faktor k multiplizierte Messspannung bereitzustellen. Somit kann die Kompensationsspannung von einem Faktor k abhängen, insbesondere einem Produkt der Messspannung und dem Faktor k. Der Faktor k hängt von den Widerständen der Stromquelle und dem Innenwiderstand der Steuerspannungsquelle ab, ist jedoch nicht abhängig von dem Lastwiderstand.

Die Verwendung der konventionellen Lehrbuchschaltung der spannungsgesteuerten Stromquelle erfordert hochpräzise Widerstände, so dass eine Lastunabhängigkeit garantiert werden kann. Ferner benötigt diese auch eine ideale Spannungsquelle, bei der der Innenwiderstand 0 Ohm beträgt. Damit können die Impedanzen an den Differenzverstärkereingängen identisch ausgelegt werden.

Die Formel

$$I_L = U_{steuer} \frac{\frac{R_{F2}}{R_{G2}^{\#}} + \frac{R_{F1}}{R_{G1}} \frac{R_{F2}}{R_{G2}^{\#}}}{R_S \left(1 + \frac{R_{F2}}{R_{G2}^{\#}}\right) + R_L \left(\frac{R_{F2}}{R_{G2}^{\#}} - \frac{R_{F1}}{R_{G1}}\right)}$$

definiert den Laststrom anhand der Widerstände der Stromquelle und der Steuerspannung, die über den zweiten Serienwiderstand an den zweiten Eingang des Differenzverstärkers angelegt ist. $R_{F1}$, $R_{F2}$ entsprechen dem ersten und zweiten Rückkopplungswiderstand, $R_{G1}$, $R_{G2}$ dem ersten und zweiten Serienwiderstand, $R_S$ dem Kopplungswiderstand und $R_L$ dem Lastwiderstand.

$$R_{G2}^{\#} = R_{G2} + R_{Steuer}$$, wobei $R_{Steuer}$ den Innenwiderstand der Steuerspannungsquelle darstellt.

Die obige Formel beschreibt den Laststrom anhand der Steuerspannung und den Widerständen in der Schaltung. Man erkennt, dass bei Abweichungen der Widerstände an den Eingängen des Differenzverstärkers der rechte Term im Nenner eine Lastabhängigkeit hervorruft. Um eine Lastunabhängigkeit des Ausgangsstroms wiederherzustellen, wird eine Spannungsmessung am Ausgang des Differenzverstärkers vorgenommen. Da die Spannungsmessung am Ausgang des Differenzverstärkers erfolgt, ist diese rückwirkungsfrei und verfälscht den Laststrom nicht. Somit werden die unbekannten Größen im Ausgangsknoten mit einer bekannten, messbaren Messspannung ersetzt, die von dem Innenwiderstand $R_{Steuer}$ der Steuerspannungsquelle und dem Widerstand $R_L$ der Last abhängt.

Es kann vorgesehen sein, dass die Steuerspannungsquelle, der Differenzverstärker und die Spannungsmesseinheit in einem Mikrocontroller implementiert sind.

Es kann vorgesehen sein, dass jeder der Eingänge des Differenzverstärkers insbesondere direkt über mindestens einen jeweiligen Serienwiderstand mit einem festgelegten Potenzial, insbesondere einem Versorgungspotenzial, elektrisch verbunden ist. Insbesondere können die Impedanzen der Serienwiderstände gleich sein.

Weiterhin kann vorgesehen sein, dass jeder der Eingänge des Differenzverstärkers insbesondere direkt über mindestens einen jeweiligen Rückkopplungswiderstand mit dem Ausgang des Differenzverstärkers elektrisch verbunden ist, wobei insbesondere einer Rückkopplungswiderstände über einen Kopplungswiderstand mit dem Ausgang des Differenzverstärkers verbunden ist.

Die Abhängigkeit muss empirisch für die Stromquelle ermittelt werden und kann beispielsweise durch Vermessung bei zwei verschiedenen Lastimpedanzen/Lastwiderständen ermittelt werden. So kann gemäß einem weiteren Aspekt ein Verfahren zum Kalibrieren der obigen spannungsgesteuerten Stromquelle vorgesehen werden, wobei bei zwei verschiedenen Lastimpedanzen/Lastwiderständen an dem Ausgang der Stromquelle eine Spannungsdifferenz der Messspannung und eine Stromdifferenz des Laststroms gemessen wird, wobei eine Steuerspannung ausgehend von einer/einem vorbestimmten Lastimpedanz/Lastwiderstand so um eine Spannungsänderung variiert wird, dass eine Laststromdifferenz erreicht wird, die der zuvor gemessenen Laststromdifferenz entspricht, wobei der vorbestimmte Faktor abhängig von einem Quotienten zwischen der Spannungsänderung und der Spannungsdifferenz der Messspannung ermittelt wird.

Somit können eine Stromdifferenz und eine Spannungsdifferenz der Messspannung bei zwei verschiedenen Lastwiderständen ermittelt werden und daraus eine Steuerspannungsänderung ermittelt werden, die benötigt wird, um die Stromänderung durch die Last zu erzeugen. Der Kompensationsfaktor ergibt sich dann als Quotient aus der benötigten Änderung der Steuerspannung und der Spannungsdifferenz.

Die obige Schaltung einer spannungsgesteuerten Stromquelle ermöglicht es, den Laststrom mit einer hohen Genauigkeit auch bei variierenden Lastimpedanzen einzustellen, ohne eine kostenintensive Aufbauweise oder hochpräzise Bauelemente, insbesondere hochpräzise Widerstände, zu verwenden. Die Steuerspannungsquelle und die Spannungsmesseinheit zur Messung der Messspannung können Komponenten eines Mikrocontrollers sein, so dass die Schaltung in kompakter Aufbauweise realisiert werden kann. Ggfs. kann auch der Differenzverstärker von dem Mikrocontroller umfasst sein.

Kurzbeschreibung der Zeichnungen

Ausführungsformen werden nachfolgend anhand der beigefügten Zeichnungen näher erläutert. Es zeigen:

Figur 1   eine schematische Darstellung eines Schaltbilds einer spannungsgesteuerten Stromquelle; und

Figur 2   ein Flussdiagramm zur Veranschaulichung der Ermittlung des Kompensationsfaktors.

Beschreibung von Ausführungsformen

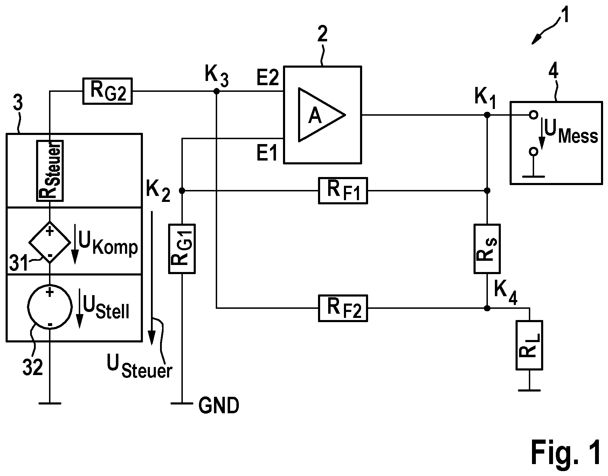

Figur 1 zeigt ein Schaltbild einer spannungsgesteuerten Stromquelle 1. Diese weist einen Differenzverstärker 2 auf, dessen erster Eingang E1 mit einem ersten Serienwiderstand $R_{G1}$ und einem ersten Rückkopplungswiderstand $R_{F1}$ gekoppelt bzw. direkt elektrisch verbunden ist. Der erste Serienwiderstand $R_{G1}$ ist mit einem ersten Anschluss an den ersten Eingang E1 des Differenzverstärkers 2 und mit einem zweiten Anschluss mit einem niedrigen Versorgungspotenzial GND, insbesondere einem Massepotenzial, insbesondere direkt, elektrisch verbunden. Ein erster Anschluss des ersten

Rückkopplungswiderstands $R_{F1}$ ist, insbesondere direkt, mit dem ersten Eingang E1 des Differenzverstärkers 2, und mit seinem zweiten Anschluss mit dem Ausgang $K_1$ des Differenzverstärkers 2 insbesondere direkt, elektrisch verbunden.

Ein zweiter Eingang E2 des Differenzverstärkers 2 ist mit einem zweiten Serienwiderstand $R_{G2}$ und einem zweiten Rückkopplungswiderstand $R_{F2}$ insbesondere direkt, elektrisch verbunden. Über den zweiten Serienwiderstand $R_{G2}$ ist der zweite Eingang E2 des Differenzverstärkers 2 mit einer Steuerspannungsquelle 3 verbunden.

Die Steuerspannungsquelle 3 ist eine reale Spannungsquelle, die gegen Masse oder ein sonstiges Referenzpotenzial eine Spannung bereitstellt, und umfasst implizit einen Innenwiderstand $R_{Steuer}$ sowie eine einstellbare Spannungsquelle, die eine Summenspannung einer von einer Stellspannungsquelle 32 bereitgestellte Stellspannung $U_{Stell}$ zum Einstellen des variablen Laststroms durch einen Lastwiderstand $R_L$ und einer von einer Kompensationsspannungsquelle 31 bereitgestellten Kompensationsspannung $U_{komp}$ bereitstellt. Die Steuerspannung $U_{Steuer}$ kann einem durch einen weiteren Schaltungsteil bereitgestelltem Steuersignal entsprechen und impedanzbehaftet sein. Diese Impedanz wird durch den Innenwiderstand $R_{Steuer}$ abgebildet.

Der zweite Eingang E2 des Differenzverstärkers 2 ist mit einem ersten Anschluss des zweiten Rückkopplungswiderstands $R_{F2}$, ein zweiter Anschluss des zweiten Rückkopplungswiderstands $R_{F2}$ ist mit dem Ausgang $K_4$ der Stromquelle 1 verbunden.

An den Ausgang $K_4$ der Stromquelle 1 kann ein Lastwiderstand $R_L$ mit variablem Widerstandswert angeschlossen werden, so dass dieser zwischen dem Ausgang $K_4$ und dem niedrigen Versorgungspotenzial GND angeschlossen ist. Der Ausgang $K_4$ der Stromquelle 1 ist über einen Kopplungswiderstand $R_S$ mit dem Ausgang $K_1$ des Differenzverstärkers 2 verbunden. Mit dem Ausgang $K_1$ des Differenzverstärkers 2 ist eine Spannungsmesseinheit 4 elektrisch verbunden, die eine Messspannung $U_{mess}$ an dem Ausgang $K_1$ bezogen auf das niedrige Versorgungspotenzial GND, insbesondere das Massepotenzial, misst.

Der Differenzverstärker 2 und der Spannungsmesseinheit 4 werden über eine Versorgungsspannung elektrisch versorgt, insbesondere mit Bezug auf das Massepotenzial GND.

Der Laststrom wird in an sich bekannter Weise durch Vorgabe der Stellspannung $U_{Stell}$ eingestellt, auf die additiv die von der Kompensationsspannungsquelle 31 bereitgestellte Kompensationsspannung $U_{komp}$ beaufschlagt wird. Die Summe beider Spannungen ergibt die Steuerspannung $U_{steuer}$, die durch an dem zweiten Anschluss des zweiten Serienwiderstandes $R_{G2}$ insbesondere direkt angelegt ist. Der Laststrom $I_L$ ergibt sich nach folgender Formel:

$$I_L = U_{Steuer} \frac{\frac{R_{F2}}{R_{G2}^{\#}} + \frac{R_{F1}}{R_{G1}}\frac{R_{F2}}{R_{G2}^{\#}}}{R_S\left(1 + \frac{R_{F2}}{R_{G2}^{\#}}\right) + R_L\left(\frac{R_{F2}}{R_{G2}^{\#}} - \frac{R_{F1}}{R_{G1}}\right)}$$

wobei hier anzumerken ist, dass $R_{G2}^{\#} = R_{G2} + R_{Steuer}$ entspricht, wobei $R_{Steuer}$ den Innenwiderstand der Steuerspannungsquelle 3 darstellt.

Die Kompensationsspannung $U_{komp}$ ergibt sich dabei aus der Messspannung $U_{mess}$ multipliziert mit einem Kompensationsfaktor k

$$U_{komp} = U_{mess} \cdot k$$

Der Kompensationsfaktor k kann durch eine oder mehrere Messungen während einer Kalibrierung der Stromquelle 1 ermittelt werden und berücksichtigt dann die Toleranzen aller in der Schaltung verwendeten Widerstände einschließlich des Innenwiderstands $R_{Steuer}$ der Steuerspannungsquelle 3.

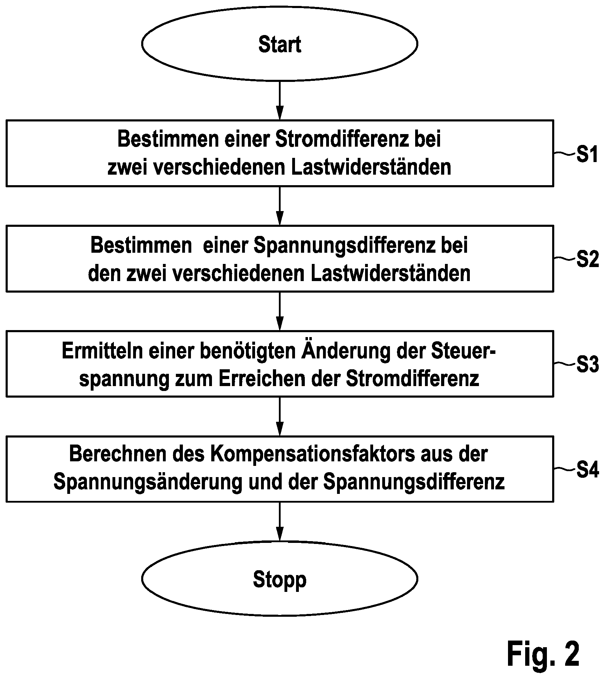

Zur Bestimmung des Kompensationsfaktors k wird ein Verfahren durchgeführt, wie es anhand des Flussdiagramms der Figur 2 veranschaulicht ist. Zunächst wird in Schritt S1 bei zwei verschiedenen, im Wesentlichen frei wählbaren Lastwiderständen $R_{L1}$ und $R_{L2}$ eine resultierende Stromänderung ΔI durch die Lastwiderstände $R_{L1}$, $R_{L2}$ gemessen. Die Stromänderung wird bei konstanter Stellspannung $U_{Stell}$ und bei $U_{komp} = 0$ bzw. k = 0 ermittelt.

Im Schritt S2 wird eine entsprechende Änderung der Messspannung Δ$U_{mess}$ an dem Ausgangsknoten $K_1$ des Differenzverstärkers 2 bei den zwei verschiedenen Lasten $R_{L1}$ und $R_{L2}$ bestimmt. Die Messspannungsänderung wird bei konstanter Stellspannung $U_{Stell}$ ermittelt.

Die Schritte S1 und S2 lassen sich kombinieren, indem zunächst der Laststrom bei einem ersten Lastwiderstand $R_{L1}$ und die entsprechende Messspannung $U_{mess}$ gemessen wird und anschließend für einen zweiten Lastwiderstand $R_{L2}$ entsprechend der Laststrom und die Messspannung $U_{mess}$ gemessen wird. Daraus lassen sich die entsprechenden Strom- und Spannungsänderungen der Schritte S1 und S2 berechnen.

Ferner wird in Schritt S3 eine Änderung der Stellspannung Δ$U_{Stell}$ ermittelt, die ausgehend von einem beliebigen Lastwiderstand, insbesondere eines Lastwiderstands zwischen den zuvor ausgewählten Lastwiderständen $R_{L1}$, $R_{L2}$, benötigt wird, um die zuvor bestimmte Änderung des Laststroms ΔI zu erzeugen.

In Schritt S4 wird der Kompensationsfaktor k berechnet als Quotient zwischen der Änderung der Messspannung Δ$U_{mess}$ und der Änderung der Stellspannung Δ$U_{Stell}$. Anschließend wird die Steuerspannungsquelle 3 mit der Kompensationsspannungsquelle 31 so konfiguriert, dass eine gewünschte Steuerspannung Usteuer zum Einstellen eines gewünschten Laststroms vorgegeben wird und eine Kompensationsspannung $U_{komp}$ beaufschlagt wird, die sich aus der Messspannung $U_{mess}$ multipliziert mit dem zuvor ermittelten Kompensationsfaktor k ergibt.

Während des regulären Betriebs kann die Stellspannung $U_{Stell}$ beispielsweise aus einem Kennfeld ausgelesen werden, das für verschiedene gewünschte Lastströme $I_L$ eine entsprechende Stellspannung $U_{Stell}$ angibt. Alternativ kann die Stellspannung $U_{Stell}$ auch durch eine funktionale Beschreibung aus dem gewünschten Laststrom $I_L$ ermittelt werden.

**Patentansprüche**

1. Spannungsgesteuerte Stromquelle (1) zum Bereitstellen eines gewünschten Laststroms durch eine Lastimpedanz ($R_L$) an einem Ausgang der Stromquelle abhängig von einer Steuerspannung ($U_{Steuer}$), umfassend:

   - eine Steuerspannungsquelle (3) zum Bereitstellen der Steuerspannung ($U_{Steuer}$);
   - einen Differenzverstärker (2) mit einem Ausgang, der auf jeden der Eingänge (E1, E2) des Differenzverstärkers (2) über einen jeweiligen Rückkopplungswiderstand rückgekoppelt ist, wobei einer der Eingänge (E2) mit der Steuerspannungsquelle (3) elektrisch gekoppelt ist,
   - eine Spannungsmesseinheit (4) zum Erfassen einer Messspannung ($U_{mess}$) an dem Ausgang ($K_1$) des Differenzverstärkers (2);

   wobei die Steuerspannungsquelle (3) ausgebildet ist, um abhängig von der Messspannung ($U_{mess}$) die Steuerspannung ($U_{Steuer}$) des Steuersignals einzustellen, so dass der gewünschte Laststrom eingestellt wird.

2. Stromquelle (1) nach Anspruch 1, wobei die Steuerspannungsquelle (3) eine Stellspannungsquelle (32) oder einen Schaltungsteil aufweist, um eine dem gewünschten Laststrom entsprechende Stellspannung ($U_{Stell}$) vorzugeben, und eine Kompensationsspannungsquelle (31) aufweist, um der Stellspannung ($U_{Stell}$) eine von der Messspannung ($U_{mess}$) abhängige Kompensationsspannung ($U_{komp}$) zu addieren, um die Steuerspannung ($U_{Steuer}$) zu erhalten.

3. Stromquelle (1) nach Anspruch 2, wobei die Steuerspannungsquelle (3) einen Innenwiderstand von mehr als 1 Ohm aufweist.

4. Stromquelle (1) nach Anspruch 2 oder 3, wobei die Kompensationsspannungsquelle (31) ausgebildet ist, um als die Kompensationsspannung ($U_{komp}$) die mit einem vorbestimmten Faktor k multiplizierte Messspannung ($U_{mess}$) bereitzustellen.

5. Stromquelle (1) nach einem der Ansprüche 1 bis 4, wobei die Steuerspannungsquelle (3) und die Spannungsmesseinheit (4) in einem Mikrocontroller implementiert sind.

6. Stromquelle (1) nach einem der Ansprüche 1 bis 5, wobei jeder der Eingänge (E1, E2) des Differenzverstärkers (2) insbesondere direkt über mindestens einen jeweiligen Serienwiderstand ($R_{G1}$, $R_{G2}$) mit einem festgelegten Potenzial, insbesondere einem Versorgungspotenzial, elektrisch verbunden ist.

7. Stromquelle (1) nach Anspruch 6, wobei die Impedanzen der Serienwiderstände ($R_{G1}$, $R_{G2}$) gleich sind.

8. Stromquelle (1) nach einem der Ansprüche 1 bis 7, wobei jeder der Eingänge (E1, E2) des Differenzverstärkers (2) insbesondere direkt über mindestens einen jeweiligen Rückkopplungswiderstand ($R_{F1}$, $R_{F2}$) mit dem Ausgang ($K_1$) des Differenzverstärkers (2) elektrisch verbunden ist, wobei insbesondere einer Rückkopplungswiderstände ($R_{F2}$) über einen Kopplungswiderstand mit dem Ausgang ($K_1$) des Differenzverstärkers (2) verbunden ist.

9. Verfahren zum Kompensieren einer spannungsgesteuerten Stromquelle (1) nach einem der Ansprüche 1 bis 6, wobei bei zwei verschiedenen Lastimpedanzen an dem Ausgang ($K_1$) des Differenzverstärkers (2) der Stromquelle (1) eine Spannungsdifferenz der Messspannung ($U_{mess}$) (S2) und eine Stromdifferenz des Laststroms gemessen wird (S1), wobei eine Steuerspannung ($U_{Steuer}$) ausgehend von einer vorbestimmten Lastimpedanz so um eine Spannungsänderung variiert wird, dass eine Laststromdifferenz erreicht wird (S3), die der zuvor gemessenen Laststromdifferenz entspricht, wobei der vorbestimmte Faktor (k) abhängig von einem Quotienten zwischen der Spannungsänderung und der Spannungsdifferenz der Messspannung ($U_{mess}$) ermittelt wird (S4).

Fig. 1

```
                    ┌─────────────────────┐
                    │        Start        │
                    └─────────────────────┘
                              │
                              ▼
          ┌──────────────────────────────────────────┐
          │   Bestimmen einer Stromdifferenz bei      │ ~S1
          │   zwei verschiedenen Lastwiderständen      │
          └──────────────────────────────────────────┘
                              │
                              ▼
          ┌──────────────────────────────────────────┐
          │  Bestimmen  einer Spannungsdifferenz bei   │ ~S2
          │  den zwei verschiedenen Lastwiderständen   │
          └──────────────────────────────────────────┘
                              │
                              ▼
          ┌──────────────────────────────────────────┐
          │ Ermitteln einer benötigten Änderung der   │ ~S3
          │ Steuer-spannung zum Erreichen der          │
          │ Stromdifferenz                             │
          └──────────────────────────────────────────┘
                              │
                              ▼
          ┌──────────────────────────────────────────┐
          │  Berechnen des Kompensationsfaktors aus    │ ~S4
          │  der Spannungsänderung und der             │
          │  Spannungsdifferenz                        │
          └──────────────────────────────────────────┘
                              │
                              ▼
                    ┌─────────────────────┐
                    │        Stopp        │
                    └─────────────────────┘
```

Fig. 2

Europäisches
Patentamt

European
Patent Office

Office européen
des brevets

# EUROPÄISCHER RECHERCHENBERICHT

Nummer der Anmeldung

EP 22 18 5229

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HERWIG LABUS ET AL: "Spannungsgesteuerte Stromquellen kleiner Leistung", ELEKTRONIK,, Bd. 21, Nr. 5, 1. Mai 1972 (1972-05-01), Seiten 165-168, XP001405833, * Zusammenfassung; Abbildung 9 * ----- | 1 | INV. G05F1/56 H03M1/66 H03M1/78 |
| X | BATISTA DANIEL S ET AL: "Howland Current Source Applied to Magnetic Field Generation in a Tri-Axial Helmholtz Coil", IEEE ACCESS, Bd. 7, 17. September 2019 (2019-09-17), Seiten 125649-125661, XP011745795, DOI: 10.1109/ACCESS.2019.2939117 [gefunden am 2019-09-13] * Zusammenfassung; Abbildungen 3,4 * ----- | 1-9 | |
| A | KHALIGHI M ET AL: "A floating wide-band current source for electrical impedance tomography", REVIEW OF SCIENTIFIC INSTRUMENTS, AMERICAN INSTITUTE OF PHYSICS, 2 HUNTINGTON QUADRANGLE, MELVILLE, NY 11747, Bd. 89, Nr. 8, 7. August 2018 (2018-08-07) , XP012230569, ISSN: 0034-6748, DOI: 10.1063/1.5028435 [gefunden am 2018-08-07] * Zusammenfassung; Abbildungen 3,4 * ----- -/-- | 1-9 | RECHERCHIERTE SACHGEBIETE (IPC) G05F H03M |

Der vorliegende Recherchenbericht wurde für alle Patentansprüche erstellt

| Recherchenort | Abschlußdatum der Recherche | Prüfer |
|---|---|---|
| Den Haag | 12. Dezember 2022 | Arias Pérez, Jagoba |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

Seite 1 von 2

EUROPÄISCHER RECHERCHENBERICHT

Nummer der Anmeldung

EP 22 18 5229

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | GUO FENG ET AL: "An Improved-Precision Voice Coil Motor Drive Method Utilizing Additional Current Feedback", 2019 22ND INTERNATIONAL CONFERENCE ON ELECTRICAL MACHINES AND SYSTEMS (ICEMS), IEEE, 11. August 2019 (2019-08-11), Seiten 1-4, XP033643093, DOI: 10.1109/ICEMS.2019.8921480 [gefunden am 2019-12-03] * Zusammenfassung; Abbildung 1 * ----- | 1-9 | |
| A | CN 213 240 428 U (SHANGHAI YUNTUN TECH CO LTD) 18. Mai 2021 (2021-05-18) * Zusammenfassung; Abbildung 1 * ----- | 1-9 | |
| A | LIN JING ET AL: "Design of wavelength-locking module for VCSEL", SPIE SMART STRUCTURES AND MATERIALS + NONDESTRUCTIVE EVALUATION AND HEALTH MONITORING, 2005, SAN DIEGO, CALIFORNIA, UNITED STATES, SPIE, US, Bd. 11930, 14. Oktober 2021 (2021-10-14), Seiten 1193026-1193026, XP060146695, ISSN: 0277-786X, DOI: 10.1117/12.2611107 ISBN: 978-1-5106-4548-6 * Zusammenfassung; Abbildung 5 * ----- | 1-9 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 12. Dezember 2022 | Arias Pérez, Jagoba |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 18 5229

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-12-2022

| Im Recherchenbericht angeführtes Patentdokument | Datum der Veröffentlichung | Mitglied(er) der Patentfamilie | Datum der Veröffentlichung |
|---|---|---|---|
| CN 213240428 U | 18-05-2021 | KEINE | |

Für nähere Einzelheiten zu diesem Anhang : siehe Amtsblatt des Europäischen Patentamts, Nr.12/82

EPO FORM P0461